# EUROPEAN PATENT APPLICATION

(11) **EP 4 030 254 A1**
(43) Date of publication of application: **20.07.2022**
(21) Application number: 22151470.6
(22) Date of filing: 13.01.2022
(51) Int. Cl.: G05B 23/02, G06Q 10/00, G07C 3/14

(54) **UNSUPERVISED MACHINE MONITORING SYSTEM**

(30) Priority: 14.01.2021 US 202163137182 P
(71) Applicant: 3D Signals, 4442537 Kfar Saba (IL)
(72) Inventor: Osokin, Yuri, Rosh Haain (IL)
(74) Representative: Harrison IP Limited

(57) **Abstract**

Methods and systems are disclosed for the unsupervised, non-intrusive monitoring of motorized machines on a shop floor. A statistical algorithm is used to train itself to distinguish between an inactive and an active state of each monitored machine. The systems and methods use inexpensive sensors, do not intervene in the operation of the machines upon installation, would not adversely affect the operation of the machines, if the monitoring system would fail, do give reliable reports, and do not require any more than negligible human training.

## Description

### Background

CNC machines are common in the modern metal processing factories. ("CNC" is a well-known abbreviation for "computer numerical control," and often simply the terminology "numerical control" is used.) The factories typically implement many CNC machines, and to maintain efficient operation it is quite desirable to know the active/inactive states of each machine. A machine may be inactive for a variety of reasons, such as temporary unavailability of a work product from another machine or unavailability of a human operator/monitor to realign a jammed work piece preventing the machine from continuing operation.

Monitoring an individual CNC machine's active/inactive state in such a factory environment is not so simple as, for example, to simply measure the current supplied to the machine and then deeming any non-zero (or very low) value as indicative that the machine is inactive. In practice, there are multiple factory environmental effects that interfere with a measured signal, such as a measured current signal. A non-exhaustive list of such effects is: electromagnetic interference from the nearby electronics, thermal noise from all electronic components, and noise generated by amplifiers used in the factory setting. Thus, the value that a sensor provides as the current supplied to a machine is not enough by itself to indicate reliably the machine's active/inactive state at the time the sensor provides that value.

A method found effective to determine active/inactive status of one CNC machine would not necessarily suffice to determine active/inactive status of many CNC machines in a single factory. There are many CNC machine manufacturers, and a single CNC machine usually has multiple motors with different electrical and mechanical parameters. In common practice, factories implement a mixed fleet of CNC machines from multiple different manufacturers. Monitoring the operation of the machines thus requires a customized monitoring system adapted to the specific characteristics of the various machines.

There are many monitoring systems known in the art, and they differ in the type of sensors used for monitoring each machine, in the level of intrusion/invasiveness of the sensors into the machines, in the level of automation, in training the monitoring system how to detect situations that require sounding an alert, and in the level of detail that the system monitors for each machine.

The state of the art in monitoring a large number of machines on a production floor is described well in the PhD thesis of Thomas McLeay, which is entitled "Unsupervised Monitoring of Machining Processes," submitted to the University of Sheffield, Sheffield, England, on December 2018. In this thesis, Dr. McLeay lists the typical types of sensors in machine monitoring systems (table 2-1, page 30). These types are dynamometers, accelerometers, acoustic sensors, and current and power sensors.

The main features that determine the value of such a multi-machine monitoring system are the level of intrusion to the machine operation, the accuracy of measured parameters in the system report, the cost of the sensors, and the amount of system training needed.

Unfortunately, there is no known conventional system available that satisfactorily addresses all four of the above aspects. What is needed is a monitoring system that would use inexpensive sensors, would not intervene in the operation of the machines upon installation, would not adversely affect the operation of the machines, if the monitoring system would fail, would give reliable reports, and would not require any more than negligible human training.

### Summary

According to a first aspect of the invention, there is provided a method of monitoring activity and inactivity of a motor as hereinafter set forth in Claim 1 of the appended claims.

According to a second aspect of the invention, there is provided a motor activity monitoring system as hereinafter set forth in Claim 6 of the appended claims.

Embodiments of the invention offer low-cost sensors for non-intrusive operation, and they report the status of each machine reliably and without requiring significant, if any, training.

To achieve this, the embodiments focus on a very basic level of monitoring, which mainly indicates whether a motor in a monitored machine is active or inactive. This very basic information, when obtained reliably and non-intrusively from the majority of the machines in a workshop, provides to the facility management a great deal of information for managing the plant.

Some embodiments place clamping current sensors on one or two of the phases of the 3-phase motor. The sensors may be clamped over one or more of the motor's power cables anywhere in the machine, and installation does not require stopping the operation of the machine.

The systems and methods disclosed herein use an unsupervised learning algorithm to distinguish between the active and inactive states of the motor.

Embodiments of the invention use an expectation maximizing statistical algorithm to acquire the statistical parameters of the sampled current of the motor in the active and inactive states. This algorithm distinguishes between the normal (Gaussian) distribution (or, as an alternative, a Poisson distribution) of an inactive state and a possibly rectangular distribution of the active state, and then determines by "expectation maximization" method and without external teaching where the threshold that distinguishes between the two states should be. "External teaching" in this context refers to indicating to the system from an external source during a training phase (discussed below) whether a given sample represents "active" or "inactive" states of a machine. The beauty of the invention is that the system automatically determines a threshold for decision without such intervention.

The embodiments may serve as a computational and physical infrastructure for implementation of more advanced detection algorithms, some of which are based on the parallel analysis of the current in two phases of the motor.

The operation of the systems and corresponding method will be better understood from the discussion of the drawings below.

The present disclosure uses the following terms defined accordingly:
- motor - a machine that transforms electrical energy into mechanical energy
- phase cable - an electric cable that provides power to a motor (in a single or multiple phase motor)
- active motor - a motor that presently converts electrical energy to mechanical energy
- inactive motor - a motor that does not presently convert electrical energy to mechanical energy
- analog sensor - a sensor that converts a physical phenomenon into an electric signal whose amplitude is related to the magnitude of the phenomenon
- current sensor - an analog sensor in which the converted sensed physical phenomenon is the flow of current
- voltage sensor - an analog sensor in which the converted sensed physical phenomenon is the voltage between two points
- power sensor - an analog sensor in which the converted sensed physical phenomenon is the amount of power consumed
- non-intrusive - a relationship between a first and a second operation in which the execution of the first operation causes negligible disturbance to the execution of the second operation
- unsupervised process - a process that can start in a common predetermined initial state and reach a customized targeted state by using only sensor data and algorithmic analysis without requiring human intervention during the process
- statistical parameter - a quantity that enters into the probability distribution of a statistic or a random variable
- expectation maximization - in statistics, an iterative method to find (local) maximum likelihood or maximum a posteriori (MAP) estimates of parameters in statistical models in which the model depends on unobserved latent variables

The invention may be embodied as a method of monitoring activity and inactivity of a motor. The method includes: non-intrusively attaching an analog sensor to at least one cable of an electric motor; applying unsupervised statistical analysis to an output signal of the sensor; computing statistical parameters of the signal when the motor is not active; and deriving, from the statistical computation, an indication of whether the motor is active.

The invention may alternatively be embodied as a motor activity monitoring system. The system has: at least one analog sensor attachable to a phase cable of a motor; and a processor configured to apply an unsupervised statistical analysis of an output signal of the sensor and to produce an indication of whether the motor is active or inactive.

### Brief description of the drawings

The invention will now be described further, by way of example, with reference to the accompanying drawings, in which:
Figure 1 compares characteristics of various types of sensors;
Figure 2 provides a simplified block diagram of a system according to one embodiment of the invention.
Figure 3 provides a simplified flowchart of a training process for use when operating the system of Figure 2;
Figure 4 provides a simplified flowchart of the monitoring process for use when operating the system of Figure 2; and
Figure 5 provides a plot of statistical distributions that embodiments of the invention, such as those of Figures 2-4, use in their operation.

### Detailed Description

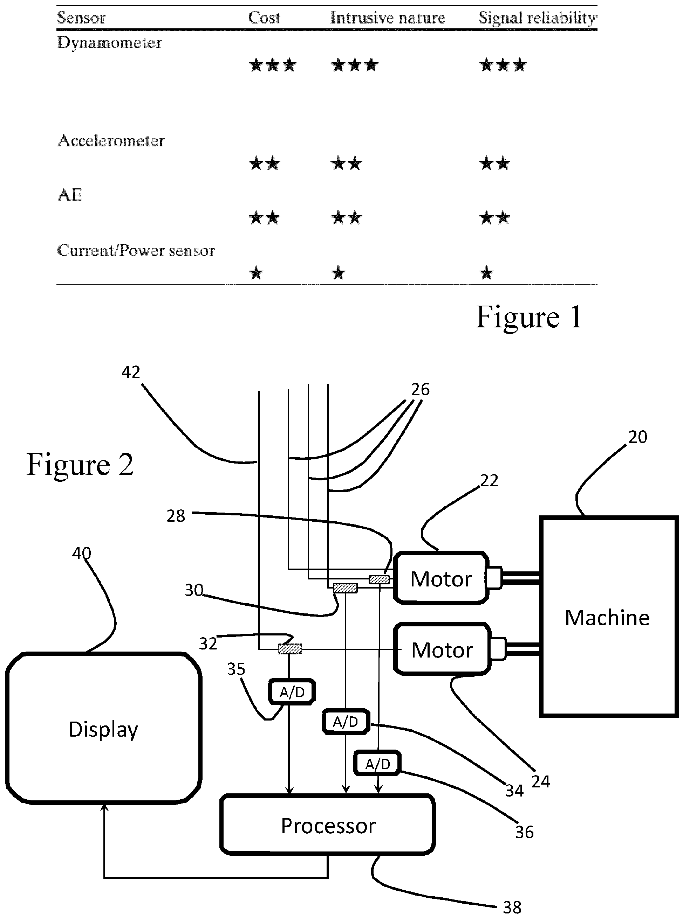

Figure 1, using information from the McLeay PhD thesis (see Background), compares characteristics to show advantages and disadvantages of several types of sensors.

Attention is now called to Figure 2.

A machine 20 in this embodiment of the invention uses a three-phase motor 22 having leads 26 and a one-phase motor 24 having a lead 42. Two phases of motor 22 have clamping current sensors 28 and 30 installed thereon, and the one phase of motor 24 has clamping current sensor 32 installed thereon. The current sensors are standard split current transformer sensors, such as SCT016S, produced by YHDC from DUZHUANG INDUSTRIAL PARK, QINHUANGDAO CITY, HEBEI PROVINCE, CHINA, as a non-limiting example.

The three outputs of the current sensors 28, 30, 32 are each input to three ADC analog-to-digital converters (ADCs) 36, 34, and 35, respectively, and the digitized data is fed to a processor 38.

The processor 38 processes the data in accordance to the flowcharts described below and automatically learns to distinguish between a monitored motor's inactive state, when the motor is not working, and the active state, when the motor is working. The state of the machine, as determined by processor 38, is displayed on display 40.

Several machines may be monitored in parallel by processor 38, and under such configuration the display presents the active/inactive states of all the monitored machines.

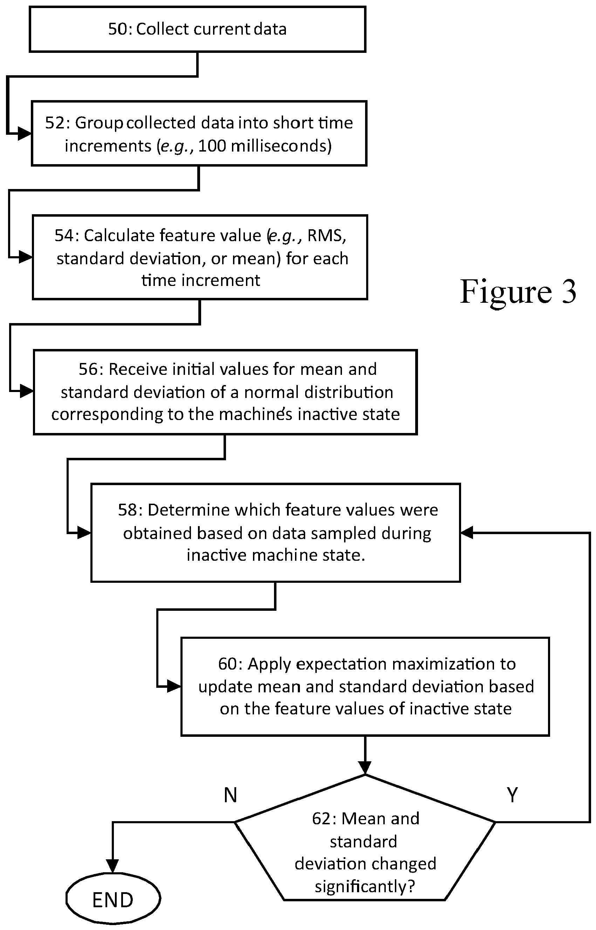

Attention is now called to Figure 3, which provides a flowchart representing the unsupervised learning algorithm implemented in one embodiment of the system.

A length of time for which sensor data are collected is chosen by one skilled in the art. In this embodiment, data from a clamping current sensor are collected 50 for a length of time equal to one-half hour. After the data collection, the unsupervised learning algorithm processes the data as follows to find a threshold value of processed current data that indicates whether the monitored machine is active or inactive.

After collecting the data of the unsupervised learning phase, the algorithm groups 52 the data according to the time increments in which they were sensed. A non-limiting example of such time increment is one lasting 100 milliseconds in duration. The samples of each time increment are processed 54 to produce a value that is used as the increment's variable of interest for the active/inactive state determination. This variable of interest is known as the "feature value," the feature in this example based on the amount of current supplied to the monitored machine. The feature value can be the mean (average), the RMS value, the standard deviation, the median, and even the minimum or maximum values of the sampled data, as non-limiting examples.

During the unsupervised learning phase of the operation of the present method, the algorithm assumes that a histogram of the feature values based on data obtained while the machine is in an inactive state forms a Gaussian distribution. The algorithm receives 56 initial values for a mean and standard deviation of the feature values of the Gaussian distribution. These initial values should be set to differ sufficiently from the first calculated mean and standard deviation, as discussed below, to cause an iteration, as also discussed below. The initial values for the mean and standard deviation may both be set to be equal to the minimum of all the feature values computed during the unsupervised learning phase. Such would reduce the risk of samples coming from the active state being classified as inactive. Alternatively, the mean can be set equal to the highest feature value and standard deviation can be set equal to the minimum feature value. The threshold for determining active/inactive state status (as clear from the discussion below) would start high and decrease with subsequent iterations until convergence. During the processing described below, the sum of the mean and the standard deviation will decrease and eventually stabilize. If the result for a set of initial values is that there is not even one iteration in the computations described below, the values would need to be reset and the feature values processed again.

Although, for reasons of clarity, this section describes the step of setting initial values of mean and standard deviation after describing the step of calculating feature values, the initial values may alternatively be set even before the data sampling even begins. Setting initial values accordingly could use the judgement of one skilled in the art to determine initial values that allow iterations (see below) but preferably not require too many to deplete time and resources.

The algorithm determines 58 as follows which feature values were obtained from data sampled when the machine was inactive: A feature value found exceeding the value of the mean of the distribution plus a pre-determined multiple of the standard deviation of the distribution is classified as obtained when the machine was active. A feature value found below that value of mean plus standard deviation multiple is classified as obtained when the machine was inactive. An example standard deviation multiple to use for this embodiment is "two."

The unsupervised learning algorithm then processes 60 the feature values considered in step 58 to be from the inactive state using an expectation maximization algorithm to converge to a new mean and the standard deviation.

Then, the algorithm determines 62 how much the newly-computed values of the mean and standard deviation of the normal distribution (signifying the inactive state) may have changed from the initial values, or alternatively since the last determination/iteration. If they changed more than a pre-determined value/tolerance set by one skilled in the art, the process returns to step 58 to perform another iteration of determining which feature values appear to have derived from data collected during an inactive state and updating the mean and standard deviation accordingly. The iteration continues, until the new mean and standard deviation and preceding mean and standard deviation differ by less than the pre-determined tolerance. At that time, the process ends.

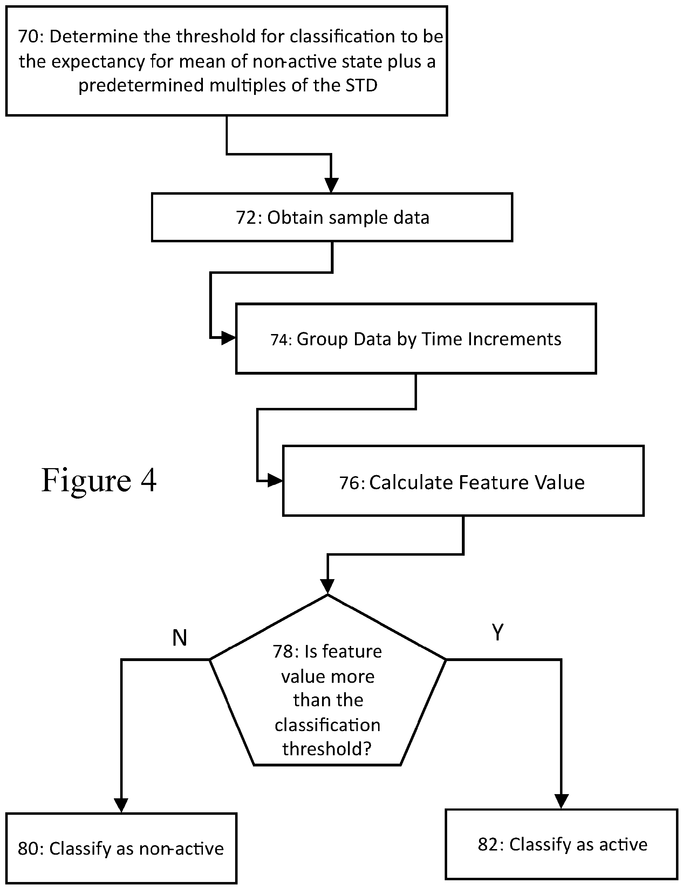

Attention is now drawn to Figure 4, which provides a flowchart representing the process of monitoring the active/inactive states of a machine. The embodiment is said to be operating at this stage in the "monitoring mode."

The algorithm determines 70 active/inactive states using as a feature value threshold the measured normal distribution's mean plus a predetermined multiple of its standard deviations, these measured values being determined during the unsupervised learning mode, using for example the embodiment described above referencing the flowchart in Figure 3. A non-limiting example of the predetermined multiple of standard deviations is "2."

The algorithm obtains 72 sampled sensor data, for example, from a current sensor, and groups them 74 according to the time increments in which they were measured, the time increments having the same duration as those of the training phase. Then, the algorithm calculates 76 the value of the feature value, for example, the RMS value, and compares that value to the threshold. If 78 the calculated feature value exceeds the threshold, the machine is determined 82 to be active at the time of data sampling for that time increment. Otherwise, the machine is determined 80 to be inactive. This process of sampling, determining feature values of time increments, and comparison with a threshold may continue for as long as the user wants machine active/inactive status information.

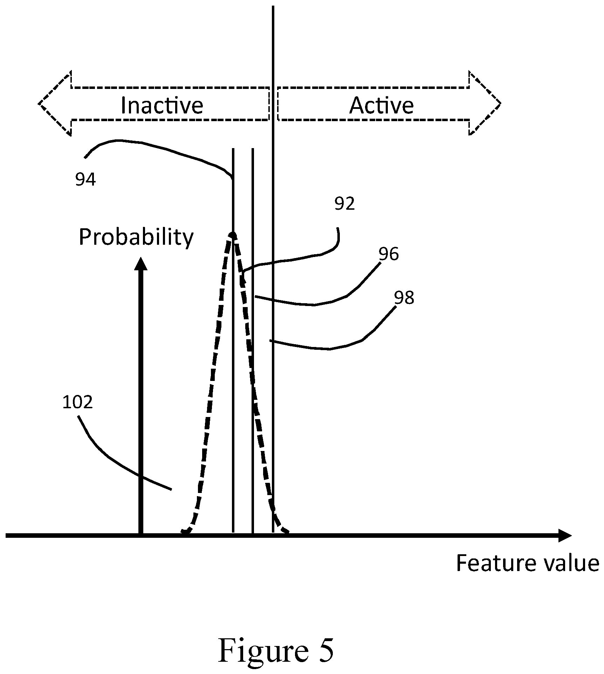

Attention is now called to Figure 5 showing the statistical distributions that the algorithms of the presently-described embodiments use.

The normal distribution 92 of the inactive state has a mean 94 and a standard distribution 96. Line 98 indicates the value of mean plus twice the standard deviation. This sum serves as the threshold for decision suitable for use in the above example embodiments.

Having thus described exemplary embodiments of the invention, it will be apparent that various alterations, modifications, and improvements will readily occur to those skilled in the art. Alternations, modifications, and improvements may be made to the described embodiments without departing from the scope of the invention as set out in the appended claims.

## Claims

1. A method of monitoring activity and inactivity of a motor, the method comprising:
non-intrusively attaching an analog sensor to at least one cable of an electric motor;
applying unsupervised statistical analysis to an output signal of the sensor;
computing statistical parameters of the signal when the motor is not active; and
deriving, from the statistical computation, an indication of whether the motor is active.

2. A method as claimed in claim 1, wherein the statistical analysis is provided at least in part by an expectation-maximization algorithm.

3. A method as claimed in claim 1 or claim 2, wherein the analog sensor is a current sensor.

4. The method of claim 1 or claim 2, wherein the analog sensor is a voltage sensor.

5. The method of claim 1 or claim 2, wherein the analog sensor is a power sensor.

6. A motor activity monitoring system comprising:
at least one analog sensor attachable to a phase cable of a motor; and
a processor configured to apply an unsupervised statistical analysis of an output signal of the sensor and to produce an indication of whether the motor is active or inactive.

7. A system as claimed in claim 6, wherein the statistical analysis is provided at least in part by an expectation-maximization algorithm.

8. A system as claimed in claim 6 or claim 7, wherein the analog sensor is a current sensor.

9. A system as claimed in claim 6 or claim 7, wherein the analog sensor is a voltage sensor.

10. A system as claimed in claim 6 or claim 7, wherein the analog sensor is a power sensor.
